(19) Europäisches Patentamt
European Patent Office
Office européen des brevets

(11) **EP 3 357 098 B1**

(12) **EUROPÄISCHE PATENTSCHRIFT**

(45) Veröffentlichungstag und Bekanntmachung des Hinweises auf die Patenterteilung:
**21.08.2019  Patentblatt 2019/34**

(21) Anmeldenummer: **15794053.7**

(22) Anmeldetag: **03.11.2015**

(51) Int Cl.:
*H01L 33/62* *(2010.01)*   *H01L 25/075* *(2006.01)*
*H01L 33/64* *(2010.01)*   *F21V 7/00* *(2006.01)*
*F21V 29/51* *(2015.01)*   *F21V 29/74* *(2015.01)*
*F21V 29/89* *(2015.01)*   *F21Y 113/00* *(2016.01)*
*F21Y 105/10* *(2016.01)*   *F21Y 115/10* *(2016.01)*

(86) Internationale Anmeldenummer:
**PCT/CH2015/000162**

(87) Internationale Veröffentlichungsnummer:
**WO 2017/075722 (11.05.2017 Gazette 2017/19)**

(54) **LED-BELEUCHTUNGSMODUL**

LED ILLUMINATION MODULE

MODULE D'ECLAIRAGE À DELS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**08.08.2018  Patentblatt 2018/32**

(73) Patentinhaber: **ADE photonExa GmbH**
**8712 Stäfa (CH)**

(72) Erfinder: **DOMBI, Adam**
**8634 Hombrechtikon (CH)**

(74) Vertreter: **Sutter, Kurt**
**E. Blum & Co. AG**
**Vorderberg 11**
**8044 Zürich (CH)**

(56) Entgegenhaltungen:
**EP-A1- 1 605 523     EP-A1- 2 421 062**
**EP-A1- 2 827 046     EP-A2- 2 386 789**
**WO-A1-2012/134305    WO-A1-2013/045353**
**DE-A1- 19 605 302    DE-A1-102007 054 856**
**DE-A1-102012 110 261  US-A1- 2011 241 549**
**US-A1- 2013 187 189   US-A1- 2015 214 194**

**EP 3 357 098 B1**

**Beschreibung**

Gebiet der Erfindung

Die Erfindung bezieht sich auf ein LED-Beleuchtungsmodul sowie auf einen LED-Leuchtkörper mit mindestens einem solchen LED-Beleuchtungsmodul gemäss Oberbegriff der unabhängigen Ansprüche. Insbesondere betrifft die Erfindung Hochleistung-LED-Lichtquellen im Bereich von einigen Watt bis mehreren kW, wie Sie z.B., aber nicht abschliessend, für allgemeine Beleuchtung, Strassenbeleuchtung, Objektbeleuchtung, Arbeitsplatzbeleuchtung, Medizin und als technische Beleuchtungen gebraucht werden.

Hintergrund

Mangels hinreichend guter Wärmeleitfähigkeit des Halbleitermaterials (typisch GaN, InGaN, AlN, AlGaN, etc.) von Hochleistungs-LEDs müssen hohe Lichtleistungen durch Zusammenfügen einzelner LED-Chips zu Arrays zusammengesetzt werden. Die gängige Technik, solche Arrays aufzubauen, besteht darin, LED-Chips (mit oder ohne Subcarrier bzw. Träger) mit Leistungen von 0.5 bis 5 Watt in SMD-Bauweise auf Aluminiumkern-Platinen als Raster (typisch in äquidistanter Gitter-Anordnung) aufzulöten oder aufzukleben. Wegen der beschränkten Wärmeleitfähigkeit von Aluminium (typisch $\lambda_{Al}$ = 75 - 235 Wm$^{-1}$K$^{-1}$) müssen Abstände von typisch 20 - 30 mm zwischen den Chips eingehalten werden - selbst wenn die Aluminiumkemplatine direkt an ein leistungsfähiges Kühlsystem angekoppelt wird. Deshalb ist die Brillianz und Leistungsdichte solcher Lösungen begrenzt. Wird z.B. auf einer Fläche von 1 dm$^2$ (100 cm$^2$) ein typisches modernes LED-Array mit 5 x 5 LED zu 5 W aufgebaut, ergibt das eine Leistung von 125 W mit einer mittleren Leistungsdichte von S = 1.25 W/cm$^2$. Für viele Anwendungen ist das schlicht zu wenig. Überdies lassen sich so nur sehr schwierig nichtplanare LED-Arrays mit annehmbarer Lichtführungsqualität realisieren.

In EP 2665092 wird ein LED-Substrat auf der Basis von Reinkupfer mit einem dünnen, hochwärmeleitenden Dielektrikum gezeigt, welches eine rund vierfache Leistungsdichte gegenüber Aluminiumsubstraten ermöglicht ($\lambda_{Cu999}$ = 401 Wm$^{-1}$K$^{-1}$). Damit steigt die realisierbare Leistungsdichte auf rund S = 5W/cm$^2$, und es können dicht gepackte LED-Cluster mit bis zu vier direkt nebeneinander liegenden 4W-LED-Chips gebaut werden. Damit wurden z.B. LED-Spots mit 3 x 4 x 4 W = 48 W (drei Cluster zu vier LED und 4 Watt/LED) möglich, die mit TIR-Linsen gebündelt, eine Strahlcharakteristik und elektrische Leistungsdaten ähnlich einer MR16 - 50 W-Halogenlampe aufweisen - aber natürlich viel mehr Licht abgeben. Das COC (Chip-on-Copper) genannte System kommt allerdings bei mehr als vier geclusterten 4W-LEDs rasch an seine Grenzen, weil Kupfer ein viel zu schlechter Wärmeleiter ist. Blendarme Hochleistungs-LED-Strassenlampen mit definierten Lichtverteilungskurven, die mit der von Natriumdampf-Hochdrucklampen (HPS) vergleichbar sind, verlangen jedoch Systemleistungen von 100 - 400 Watt, und zwar mit Linear-LED-Arrays (Linienstrahler-Cluster) mit Strahlerabmessungen von rund 2.5 x 38mm pro 50W-Modul (4.5 x 38 mm beim 100W - Modul) und Lambert'scher Strahlcharakteristik. Das entspricht einer Leistungsdichte von rund S = 52W/cm$^2$ bzw. 58W/cm$^2$ - also über dem zehnfachen der bisher erzielbaren Leistungsdichte - was übrigens etwa der Leistungsdichte einer Dachdecker-Lötlampe entspricht. Überdies sollen die Arrays auch nichtplanar (d.h. in dreidimensionaler Geometrie) aufgebaut werden können, um diese in handelsübliche symmetrisch-parabolische und halbellipsoide Reinaluminium-Reflektoren einbauen zu können, damit die erforderliche Blendarmut gewährleistet wird.

Ein Beleuchtungsmodul gemäss Oberbegriff von Anspruch 1 wird in WO 2012/134305 offenbart.

Darstellung der Erfindung

Es stellt sich deshalb die Aufgabe, ein LED-Beleuchtungsmodul sowie einen LED-Leuchtkörper bereitzustellen, mit denen hohe Leistungsdichten erzielt werden können. Diese Aufgabe wird vom Gegenstand gemäss den unabhängigen Ansprüchen erfüllt.

Demgemäss besitzt das LED-Beleuchtungsmodul mehrere LED-Elemente, von denen jedes einen LED-Halbleiterchip aufweist. Die LED-Elemente sind auf einem Substrat montiert. Um die Wärme von den LED-Elementen abzuleiten, ist mindestens ein Sekundär-Kühlelement vorgesehen. Um den LED-Elementen Strom zuzuführen, ist ein Stromzuführungselement vorgesehen. Dieses ist beabstandet vom Substrat angeordnet und weist Stromzuführungsleitungen für die LED-Elemente auf, welche mit den LED-Elementen verbunden sind, wobei jedes LED-Element einen elektrisch isolierenden Träger und einen LED-Chip auf einer ersten Seite des Trägers aufweist, wobei die LED-Elemente direkt oder indirekt auf dem Sekundär-Kühlelement angeordnet sind und sich im thermischen Kontakt mit diesem befinden, wobei das Stromzuführungselement parallel zu und beabstandet vom Substrat verläuft, so dass zwischen dem Stromzuführungselement und dem Substrat ein Luftspalt ausgebildet ist, wobei am Träger jedes LED-Elements auf einer der ersten Seite gegenüber liegenden zweiten Seite Kontaktstellen vorgesehen sind, welche direkt auf das Stromzuführungselement aufgelötet sind.

Das Stromzuführungselement weist eine Vielzahl von voneinander beabstandeten Zungen auf, wobei jede der Kontaktstellen mit einer der Zungen verbunden ist. Für die Kontaktstellen jedes LED-Elements sind zwei separate Zungen vorgesehen.

Auf diese Weise kann die Wärmeabfuhr von der Stromzuführung getrennt werden, so dass das Sekundär-Kühlelement sowie das Stromzuführungselement für ihre jeweilige Aufgabe optimiert werden können. Indem für die Kontaktstellen jedes LED-Elements zwei separate Zungen vorgesehen sind, werden die thermischen Spannungen reduziert.

Das erwähnte Substrat kann vom Sekundär-Kühlelement gebildet werden, oder es kann sich um ein Bauteil zusätzlich zum Sekundär-Kühlelement handeln, das mit dem Sekundär-Kühlelement im Wärmekontakt steht.

Mit Vorteil besitzt das Sekundär-Kühlelement eine erste Materialschicht, wobei auf einer ersten Seite dieser ersten Materialschicht LED-Elemente direkt oder indirekt angeordnet sind. Weiter besitzt das Sekundär-Kühlelement eine zweite Materialschicht, welche an eine zweite Seite der ersten Materialschicht anschliesst, wobei die zweite Seite der ersten Seite gegenüberliegt. Dabei ist der phononische Brechungsindex $n_{\delta 1}$ der ersten Materialschicht kleiner ist als der phononische Brechungsindex $n_{\delta 2}$ der zweiten Materialschicht. Der phononische Brechungsindex eines Mediums dabei gegeben ist durch

$$n_\delta = \frac{C_{Medium}}{\rho_{Medium}} \cdot \frac{1}{n_{\delta c}} + 1,$$

wobei $C_{Medium}$ die Wärmekapazität des Mediums ist, $\rho_{Medium}$ die Dichte des Mediums und $n_{\delta c}$ = 1 $s^2kg^2K/m^5$.

Wie weiter unten im Detail diskutiert, erlaubt es diese Materialwahl, die Wärme in einer Ebene parallel zur ersten Seite effizient wegzuleiten, wodurch in dieser Richtung die Temperaturgradienten und die damit verbundenen Materialspannungen reduziert werden können.

Zusätzlich oder alternativ hierzu kann das Sekundär-Kühlelement mehrere Heatpipes aufweisen, um die Wärme von den LED-Elementen fortzutragen.

Die Erfindung betrifft auch einen LED-Leuchtkörper mit mindestens einem solchen LED-Beleuchtungsmodul sowie mit mindestens einen Tertiär-Kühlelement, welches zum Fortführen von Wärme thermisch mit dem Sekundär-Kühlelement verbunden ist.

## Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:

Fig. 1 ein LED-Element auf einem Sekundär-Kühlelement,
Fig. 2 ein einzeiliges LED-Modul in Draufsicht,
Fig. 3 das Modul von Fig. 2 in Seitenansicht,
Fig. 4 das Stromzuführungselement für das LED-Modul
Fig. 5 ein zweizeiliges LED-Modul in Draufsicht,
Fig. 6 das Modul von Fig. 3 in Seitenansicht,
Fig. 7 eine erste Ausführung eines LED-Leuchtkörpers mit dem Modul von Fig. 2 und 3 in Seitenansicht,
Fig. 8 ein LED-Leuchtkörper mit dem Modul von Fig. 2 und 3 und mit Reflektor und
Fig. 9 ein LED-Leuchtkörper mit dem Modul von Fig. 5 und 6 und mit Reflektor.

## Wege zur Ausführung der Erfindung

*Verteilung der Abwärme der LED-Elemente*

Grundsätzlich ist es bekannt, die LED-Elemente (welche die LED-Chips und einen elektrisch isolierenden Träger umfassen) auf einem Sekundär-Kühlelement anzuordnen, das die Wärme von den LED-Elementen ableitet. Das Sekundär-Kühlelement ist seinerseits mit einem Tertiär-Kühlelement, z.B. einem Kühlkörper verbunden.

Ein Ziel der vorliegenden Erfindung bestand einerseits darin, eine bessere Wärmeleitungsgeometrie zu finden, als das bei herkömmlichen Lösungen möglich ist, weil alleine schon die Temperaturgradienten zwischen den geclusterten (d.h. dicht gepackten LED-Chips) rasch mehrere K/mm betragen können, was zu grossen Materialspannungen, Rissen und Ermüdungsbrüchen in den Chip-Lötstellen führen kann. Andrerseits musste ein Material, bzw. eine Materialverbindung gefunden werden, welches eine möglichst hohe Wärmeleitfähigkeit, vorzugsweise mindestens zehnmal höhere Wärmeleitfähigkeit als Kupfer, aufweist. Alsdann musste ein Interface-System entwickelt werden, welches die Wärme der LED-Cluster mit geringen Temperaturgradienten zum Kühlkörper, d.h. zum Tertiär-Kühlelement, transportieren kann, um Spannungsrisse in den Lötstellen zu vermeiden.

Um eine LED-Lebensdauer von z.B. 100'000 h zu erzielen, dürfen die Sperrschicht-Temperaturen zudem einen Bereich von 50...80°C nicht überschreiten.

Die LED-Elemente werden direkt oder indirekt auf dem Sekundär-Kühlelement angeordnet und befinden sich im thermischen Kontakt mit diesem.

Wie unten genauer beschrieben, werden elektrischen Anschlüsse der LED-Chips mit Vorteil auf ein Stromzuführungselement, beispielsweise eine herkömmliche FR4-Leiterplatte, aufgelötet, in welchem Schlitze zwischen den Anschlüssen eingefräst sind. Mit anderen Worten besitzt das Stromzuführungselement eine Vielzahl von zum Substrat hin gerichteten, voneinander beabstandeten Zungen, wobei jede Lötstelle der LED-Elemente mit einer der Zungen verbunden ist. Auf diese Weise können Scherkräfte aufgrund der unterschiedlichen Ausdehnungskoeffizienten des Sekundär-Kühlelements, des LED-Elements und des Stromzuführungselements aufgefangen werden.

Auf dem Sekundär-Kühlelement können die LED-Elemente direkt in einer oder zwei Riehen geclustert (d.h. ohne nennenswerte Abstände) aufgelötet werden. Das unterdrückt einen longitudinalen (d.h. in Substratrichtung verlaufenden) Wärmetransport - und damit lokale Temperaturgradienten, welche die Lötstellen beschädigen können.

Weiter kann ein der Leistung angepasstes Kühlinterface eingesetzt werden, (d.h. ein mechanisches Montageverfahren samt einer Ankopplung an das Kühlsystem mit einer Wärmeverteilung, welche sich durch geringe Temperaturgradienten auszeichnet). Hierzu erweisen sich zwei Techniken als besonders einfach realisierbar und wirtschaftlich. Diese werden im Folgenden beschrieben.

"*Heat-Spreader*" *Technik*

Diese Technik eignet sich insbesondere für niedrigere Leistungen, d.h. für Arrays von LED-Elementen in ein bis drei Reihen zur Bildung von LED-Beleuchtungsmodulen mit 50 bis 150 W Gesamtleistung in planarer Geometrie.

Hierbei wird ein "Heat-Spreader" (Wärmeverteiler) eingesetzt, der eine möglichst gute Wärmeleitung in der Ebene parallel zur Ebene der LED-Elemente besitzt. Der Head-Spreader ist als Teil des Sekundär-Kühlelements realisiert.

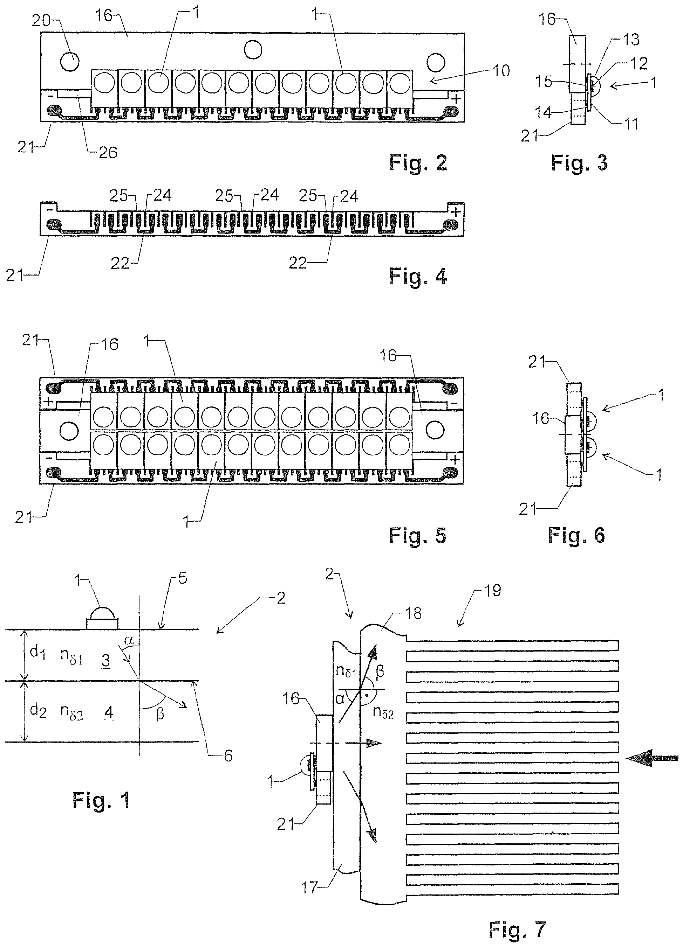

Fig. 1 illustriert eine entsprechende Anordnung. Zur Illustration ist in Fig. 1 als Wärmequelle ein einzelnes LED-Element 1 eingezeichnet, wobei in der Regel jedoch mehrere solcher LED-Elemente nebeneinander vorgesehen sind. Das LED-Element 1 ist auf einem grossflächigen Sekundär-Kühlelement 2 montiert. In der gezeigten Ausführung ist das Sekundär-Kühlelement als Verbund mehrerer Materialschichten ausgestaltet.

Die LED-Elemente 1 sind direkt oder indirekt auf einer ersten Materialschicht 3 des Sekundär-Kühlelements 2 angeordnet, und zwar auf einer ersten Seite 5 der ersten Materialschicht 3. Die erste Materialschicht 3 besteht aus einem Material mit hoher thermischer Leitfähigkeit, insbesondere aus Reinstkupfer. Die Dicke der ersten Materialschicht 3 beträgt mit Vorteil mindestens 0.5 mm und/oder höchstens 3 mm. Die Untergrenze ergibt sich aufgrund der gewünschten mechanischen Stabilität. Die Obergrenze hängt von der lateralen Ausdehnung des Wärme erzeugenden Bereichs der LED-Elemente 1 ab, insbesondere von der der lateralen Ausdehnung der LED-Chips. Mit Vorteil entspricht die Dicke höchstens der lateralen Ausdehnung, insbesondere etwa der halben lateralen Ausdehnung, der LED-Chips, da auf diese Weise der laterale Wärmetransport in der ersten Materialschicht, der zu einem Abheben der Schicht führen kann, reduziert wird.

Die LED-Elemente 1 können, wie in Fig. 1 gezeigt, direkt auf der ersten Materialschicht 3 angeordnet werden, z.B. mittels Löten, in welchem Falle die Materialschicht 3 das Substrat zur Aufnahme der LED-Elemente 1 bildet.

Alternativ können die LED-Elemente 1 (wie bei den späteren Ausführungsbeispielen gezeigt) auf einem von der ersten Materialschicht 3 gentrennten Substrat mit hoher thermischer Leitfähigkeit, z.B. auf einer 0.8 bis 1.2 mm dicken Platte aus Metall, insbesondere aus walzhartem Reinstkupfer, befestigt sein, wiederum insbesondere durch Löten. Das Substrat wird sodann auf der in Fig. 1 gezeigten Schicht 3 wärmeleitend montiert, z.B. durch Schrauben und unter Verwendung einer Wärmeleitpaste.

Mit Vorteil besteht das Substrat aus dem gleichen Material wie die erste Materialschicht.

Eine zweite Materialschicht 4 des Sekundär-Kühlelements 2 schliesst an eine zweite Seite 6 der ersten Materialschicht 3 an, wobei die zweite Seite 6 der ersten Seite 5 der ersten Materialschicht 3 gegenüber liegt. Die zweite Materialschicht 4 besteht aus einem Material geringerer thermischer Leitfähigkeit, insbesondere aus Aluminium. Ihre Dicke beträgt mit Vorteil 0.5 bis 12 mm, abhängig von der Wärme aufnehmenden Fläche des Tertiär-Kühlsystems, welches die Wärme an die Umgebung abgibt. Das Optimum wird durch die konkrete Geometrie bestimmt. Ist die Wärme aufnehmende Fläche des Tertiär-Kühlsystems gross, wird mit Vorteil eine grosse Dicke gewählt.

An die zweite Materialschicht kann z.B. ein Kühlkörper (typisch ein durch Kühlluft durchströmtes Hohlprofil) als Tertiär-Kühlelement anschliessen (nicht gezeigt).

Diese Kupfer/Aluminium -Konstruktion gleicht einerseits die Z-Position der Isothermenflächen aus, d.h. die Temperaturgradienten in der Richtung parallel zur Oberfläche bzw. Seite 5 ist gering. Damit wird ein stabiler und störungsfreier Betrieb ohne Spannungsrisse an den LED-Lötstellen möglich. Weiter wirkt das Verbundmaterial als Wärmeverteiler (Heat-Spreader) - und zwar, wie eine optische fokale Verkürzungsplatte - indem für eine gewünschte Wärmeverteilung mit einer Leistung $P_{th}$ über eine gegebene Fläche $A$ deutlich weniger Materialdicke $d$ mit einer ebenfalls gegebenen spezifischen Wärmeleitfähigkeit $\lambda$ durchquert werden muss, als bei einem einzigen, hochwärmeleitenden Material. Damit sinkt der scheinbare Wärmewiderstand $R_{th}$ - und damit auch die Temperaturdifferenz $\Delta T$. Im stationären, homogenen Fall gilt

$$R_{th} = \frac{d}{\lambda \cdot A} = \frac{\Delta T}{P_{th}} \qquad \text{Gl. 1; 2}$$

Die Wärmeleitungsgleichung $T=u(x, y, z, t)$ liefert zwar die exakte Temperatur eines Festköpers an einem bestimmten Punkt zu einer bestimmten Zeit. Die Bestimmung der Gradienten als Normalen zu den Isothermenflächen ist jedoch sehr aufwendig. Deshalb wird zur Analyse ein vereinfachter quantentheoretischer Ansatz mittels Phononen verwendet. (Ein Phonon oder Deltron (Symbol $\delta$) ist ein quantenmechanisches Quasi-Austauschteilchen für den Wärmefluss dQ/dt.). Dieser Ansatz weist zwar bei grossen Divergenzwinkeln einen schnell ansteigenden Fehler auf, ermöglicht dafür bei kleinen Winkeln bei hinreichender Genauigkeit eine deutliche Vereinfachung der Auslegung - auf Kosten der Zeitinformation.

Dazu wird der Begriff der phononischen Brechung - analog zur photonischen, dielektrischen und magnetisch permeablen Brechung an Grenzflächen zwischen den Materialschichten - eingeführt. So können die Temperaturgradienten ohne aufwändige Rechnung im Zeitbereich als Wärmeflusspfad-Vektoren dargestellt werden - in Analogie zu einem optischen Pfad, der durch Grenzflächen führt.

Dies wird erreicht, indem die Unterschiede im phononischen Brechungsindex $n_\delta$ der beiden Materialien für die Erhöhung der räumlichen Wärmedispersion definiert werden. So kann in erster Näherung das Brechungsgesetz von Snellius in inverser Form verwendet werden. Voraussetzung dafür ist das Vorhandensein von Brechungsindizes für die beteiligten Medien. Für elektromagnetische Wellen, sowie elektrische und magnetische Felder, wird der Brechungsindex $n$ als Quotient zwischen der Ausbreitungsgeschwindigkeit im Medium $v_m$ zur Vakuumlichtgeschwindigkeit $c$ definiert.

$$n = \frac{c}{v_m} \qquad \text{Gl. 3}$$

Die Ausbreitungsgeschwindigkeit eines phononischen Schrittes $T_0 \cdot 1(t)$ in einem Festkörper - mit $\Delta T_0$ als Schritttemperatur - lässt sich auf diese Weise weder sinnvoll messen, noch definieren, da die Übertragungsfunktion der Wärmeleitung bei kleinen Weglängen (d.h. Vernachlässigung der Transportverzögerung) ein PT1-Glied in der Laplace-Domäne G(s) mit der Temperaturdifferenzamplitude $\Delta T_0$ und der Zeitkonstante $\tau$ darstellt.

$$G(s) = \frac{\Delta T_0}{1 + \tau \cdot s} \qquad \text{Gl. 4}$$

Folglich erhält man für den Temperaturverlauf im Zeitbereich $T(t)$ eine exponentielle Sättigungsfunktion als Schrittantwort mit

$$T(t) = \Delta T_0 (1 - e^{-\frac{t}{\tau}}), \qquad \text{Gl. 5}$$

was entfernt an die Fundamentallösung der Wärmeleitungsgleichung für den eindimensionalen Fall erinnert. Ist das Verhältnis der Flächen $A$ des durch die Phononen zu durchquerenden Materialien zur Dicke $d$ sehr gross und sind die Materialstärken erst noch etwa im gleichen Bereich (wenige mm) dann spielen die Unterschiede in den Zeitkonstanten zwar keine vernachlässigbare, aber gleichwohl eine untergeordnete Rolle. Zur Vereinfachung wurde sie auf Kosten eines mit dem Dispersionswinkel rasch wachsenden Fehlers trotzdem weggelassen.

Aus rein logischen Überlegungen heraus kann man den phononischen Brechungsindex $n_\delta$ mit $\rho_{Medium}$ (Dichte des Mediums in kg/m$^3$) und der spezifischen Wärmekapazität $C_{Medium}$ (J·K$^{-1}$·kg$^{-1}$), sowie dem mit 1 normalisierten Brechungsindex $n_{\delta c}$ = 1 s$^2$kg$^2$K/m$^5$ als formalen Ersatz für die Vakuumlichtgeschwindigkeit, vereinfacht schreiben als

$$n_\delta = \frac{C_{Medium}}{\rho_{Medium}} \cdot \frac{1}{n_{\delta c}} + 1 \qquad \text{Gl. 7}$$

Damit erhalten wir eine dimensionslose Grösse, die wir in das Brechungsgesetz von Snellius in *inverser* Form als Approximation mit den *Bedingungen* $n_{\delta 1} < n_{\delta 2}$ und $\lambda_1 > \lambda_2$ einsetzen können; wobei $\lambda_n$ die Wärmeleitfähigkeit der jeweiligen Materialschicht ist:

$$\frac{\sin(\alpha)}{\sin(\beta)} \approx \frac{n_{\delta 1}}{n_{\delta 2}} \qquad \text{Gl. 8}$$

Die Winkel $\alpha$ und $\beta$ sind in Fig. 1 eingezeichnet.

Durch die Durchtrittswinkelvergrösserung und die damit einhergehende infinitesimale Flächenvergrösserung $dA_{Quelle} \rightarrow dA_{Senke}$ pro Phonon lässt sich erreichen, dass der spezifische Gesamtwärmewiderstand des Werkstoffverbundes deutlich niedriger erscheint als der Wärmewiderstand, der sich aus dem transversalen Wärmefluss des besser wärmeleitfähigen Metalls des Verbundes ergeben würde. Selbstredend funktioniert diese scheinbare "Verringerung" des spezifischen Wärmewiderstandes nur in der ein- oder zweidimensionalen divergenten Wärmetransport-Anwendung (z.B. wenn die Wärme einer Punkt- oder linienförmigen Wärmequelle auf eine grossen Kühlfläche verteilt werden kann). Erfolgt der Wärmetransport rein senkrecht zur Durchtrittsebene, dann verschwindet die Brechung und die Wärmewiderstände addieren sich - gemäss den bekannten Gesetzen.

Deswegen sollte die Ausdehnung des Sekundär-Kühlelements ausreichend gross sein. Werden die LED-Elemente entlang einer Richtung X in einer Reihenanordnung der Breite B angeordnet (in einer Reihe oder in zwei parallelen, aneinander anliegenden Reihen), so sollte die Ausdehnung des Sekundär-Kühlelements 2 senkrecht zur Linie X und parallel zur LED-Elemente-seitigen Oberfläche des Sekundärkühlelements 2 mindestens 2·B, insbesondere mindestens 5·B, betragen.

Wegen der eingangs erwähnten Vereinfachungen entstehen auch Fehler, die für kleine Winkel nach Messungen im Bereich von etwa +10% liegen. Ab einem Eintrittswinkel von etwa 45° wächst der Fehler rasch an und verlässt für den Cu-Al-Verbund für $\alpha > 51.5169°$ den Definitionsbereich der arcsin-Funktion. Für die Auslegung eines Kühlsystems reicht jedoch diese Genauigkeit erfahrungsgemäss völlig aus, weil die laterale Temperaturdifferenz eine Gauss-Verteilungsfunktion darstellt, bei der bei der bei 90° Vollwinkel die relative Temperaturdifferenz $\Delta T(\Phi=\pm 45°)/\Delta T(\Phi=0°)$ bereits beidseitig den $1/e^2$-Wert (rund 13.5%) unterschreitet. Auf eine genauere Berechnung von $n_\delta$ wird darum an dieser Stelle verzichtet. Numerisches Beispiel:

$C_{Cu}$ = 382 J·kg$^{-1}$·K$^{-1}$ $\rho_{Cu}$ = 8960 kg/m$^3$ $\Rightarrow$ n$_{\delta Cu}$ = n$_{\delta 1}$ = 1.0426
$C_{Al}$ = 896 J·kg$^{-1}$·K$^{-1}$ $\rho_{Al}$ = 2'700 kg/m$^3$ $\Rightarrow$ n$_{\delta A1}$ = n$_{\delta 2}$ = 1.3319

Für einen Winkel $\alpha$ = 45° ergibt sich nach Umstellen von Gl. 8 und Einsetzen

$$\beta = \arcsin\left(\frac{\sin(\alpha)\,n_{\delta 2}}{n_{\delta 1}}\right) = 64.5972° \qquad \text{Gl. 9}$$

Da die Dispersion mit dem inversen Cosinus der Winkeldifferenz geht, erfahren zwei parallel laufende Phononen mit der infinitesimalen Distanz $dS_1$ die Dispersion $dS_2 = dS_1/\cos(\beta-\alpha)=1.0615 \cdot dS_1$. Die Flächenleistungsdichte $S$(W/m$^2$) geht sogar im Quadrat, was einem Leistungsdispersionsfaktor $S_1/S_2$ von 1.1268 entspricht.

"*Heatpipes*"

Für hohe Leistungen im Bereich 100...400 Watt - besonders aber in dreidimensionalen, nichtplanaren Arrays lässt sich die unter lit. a) beschriebene Technik nicht mehr ohne Weiteres oder für sich alleine anwenden, weil die extrem hohen thermischen Leistungsdichten zu sehr grossen lokalen Temperaturgradienten führen, die wiederum wegen der lokal unterschiedlichen thermischen Ausdehnung des Kupfers hohe Scherkräfte - über die Bruchgrenze hinaus - an den wärmeübertragenden Lötstellen der LED-Chips verursachen.

Für diese Anwendung wird ein thermo-mechanisches Wärmeverteilungs- und Wärmeleit-Interfacesystem vorgeschlagen, bei dem die Wärme des gemeinsamen LED-Array-Kühlpads auf kürzestem Weg, d.h. senkrecht durch eine relativ dünne Kupferschicht, in ein Array von Wärmerohren (Heatpipes) eingeleitet wird, welches - je nach Erfordernis und Einbaulage - senkrecht oder waagrecht zur Strahlerrichtung verläuft und in Bohrungen einer Kupferplatte eingelötet oder, z.B. mittels silberbeladenem Wärmeleit-Epoxy, eingeklebt werden. Auch eine wärmeleitende Klemmung der Wärmerohre ist möglich.

Unter einer Heatpipe bzw. einem Wärmerohr wird dabei ein hermetisch gekapseltes Rohr verstanden, in welchem ein Fluid eingebracht ist, das im heisseren Bereich des Wärmerohrs verdampft und im kühleren Bereich des Wärmerohrs kondensiert und so Wärme zwischen den beiden Bereichen transportiert.

Ein im Sekundär-Kühlelement eingebettetes Wärmerohr-Array besitzt gegenüber herkömmlichen Sekundärkühlsystemen einige gewichtige Vorteile:

- Es können lateral (d.h. in der Montageebene der LED-Arrays) homogene Wärmewiderstände erzielt werden, die um Grössenordnungen niedriger sind, als diejenigen von Aluminium, Gold, Kupfer oder Silber.
- Die Array-Bauweise verleiht dem Kühlsystem Redundanz. Bei entsprechender Auslegung kann eine bestimmte Anzahl von Wärmerohren ausfallen, ohne einen Ausfall des gesamten Beleuchtungssystems zu bewirken. Eine Temperaturüberwachung kann dabei sicherstellen, dass die LED-Arrays auch im Fehlerfalle nicht thermisch zerstört werden.
- Mit Leistungen bis von mehreren 100 Watt eröffnet die Technologie die Möglichkeit, extrem kompakte, langlebige und brillante LED-Hochleistungslichtquellen für alle erdenklichen Anwendungen zu bauen. Die Möglichkeit, dreidimensionale Hochleistungs-LED-Arrays zu bauen, eröffnet zudem neue Möglichkeiten in der LED-Beleuchtungstechnik, die bislang nur Bogen- oder Halogenleuchtmitteln vorbehalten waren.
- Als Wärmerohre (Heatpipes) können kostengünstige Drahtgitter-Typen (Mesh-Type) mit Wasser als Wärmetransportmedium eingesetzt werden. Betriebstemperaturen unter dem Gefrierpunkt sind trotzdem kein Problem, weil Spannungsrisse durch die Ausdehnung des gefrorenen Arbeitsfluids konstruktiv vermieden werden können und das umgebende Kupfer solange die Wärmeleitung beim Start des LED-Systems übernimmt, bis der Schmelzpunkt des Wassers überschritten ist. Danach beginnen die Wärmerohre in spezifizierter Weise zu arbeiten.
- Das System ist materialsparend und mittels gängiger Prozesse (Bohren/Fräsen, Löt- oder Klebetechnik, etc.) industriell günstig herstellbar.

*Kombination von "Heatpipes" und "Heat-Spreader"*

Die Systeme gemäss den beiden vorangehenden Abschnitten können kombiniert werden. Damit können die Vorteile beider Lösungen vereinigt werden, wo z.B. ein symmetrischer oder teilsymmetrischer Reflektor durch zwei einander gegenüberliegende, auf einer planen Sekundärkühlplatte gemäss Abschnitt "Heat-Spreader" montierte, lineare LED-Arrays realisiert wird. Im Sekundär-Kühlelement wird die Wärme mittels Heatpipes auf einen senkrecht dazu, d.h. stirnseitig, angeordneten Finnen-Kühlkörper übertragen (siehe unten).

*Erste Ausführung LED-Beleuchtungsmodul*

Eine erste Ausführung unter Verwendung der "Heat-Spreader" Technik wird in Fig. 2 - 4 und 7 dargestellt.

In der dargestellten Ausführung ist ein LED-Linienstrahler (ein Linear-Array) 10 aus mehreren LED-Elementen 1 vorgesehen. Bei den LED-Elementen 1 handelt es sich beispielsweise um zwölf LEDs des Typs Phillips-Lumi-LED-Rebel® mit einer totalen Anschlussleistung von $P_{elektrisch} \leq 50$ W.

Die hier verwendeten LED-Elemente 1 besitzen jeweils einen elektrisch isolierenden Träger 11, wobei an einer ersten Seite des Trägers 11 ein LED-Chip 12 angeordnet ist (vgl. Fig. 3), der mit einer geeigneten Optik 13 zusammenwirken kann. Auf der zweiten Seite des Trägers 11 (welche der ersten Seite des Trägers 11 gegenüber liegt), sind vorzugsweise elektrische Kontaktstellen 14 vorgesehen, über welche Strom an die LED-Elemente 1 angelegt werden kann. Weiter ist auf der zweiten Seite des Trägers 11, in einem Bereich gegenüber dem LED-Chip 12, mindestens ein Wärmeleitpad 15 angeordnet, welches der Wärmeableitung dient und vorteilhaft von einem lötfähigen Metallbereich gebildet wird.

Das Sekundär-Kühlelement 2 des LED-Beleuchungsmoduls ist in der gezeigten Ausführung mehrteilig ausgeführt. Zum einen ist ein Substrat 16 aus walzhartem Elektrolyt-Reinkupfer vorgesehen, welches mittels einer Ni/Ag-Schicht vor Korrosion geschützt sein kann. Dieses ist auf einer Platte 17 aus Kupfer montiert, an welche ein Aluminiumblock 18 anschliesst (vgl. Fig. 7). Dabei ist der Aluminiumblock 18 auf der den LED-Elementen 1 gegenüberliegenden Seite des Substrats 16 angeordnet und bildet beispielsweise Teil eines Rippenkühlkörpers 19. Der Rippenkühlkörper 19 dient auch als Tertiär-Kühlelement.

Die Platte 17 und der Aluminiumblock 18 bilden zusammen, wie in Fig. 7 illustriert, einen Heat-Spreader der in Fig. 1 gezeigten Art, wobei die Platte 17 die erste Materialschicht 3 und der Aluminiumblock 18 die zweite Materialschicht 4 bilden.

Zwischen der Platte 17 und dem Aluminiumblock 18 kann Hochleistungs-Wärmeleitpaste vorgesehen sein, ebenso zwischen dem Substrat 16 und der Platte 17. Im Substrat 16 sind Öffnungen 20 vorgesehen, in welche Schrauben zum Verbinden des Substrats 16 mit der Platte 17 und dem Aluminiumblock 18 angeordnet werden können. Denkbar ist auch eine Verbindung der Teile mittels eines Zentrierschraubbolzens oder auch mit einem niedrigschmelzenden Lot (z.B. auf Bismut- oder Indium-Basis). Auch eine Klebung mittels eines wärmeleitenden Hochleistungsklebers (z.B. auf Silber-Basis) ist möglich.

Die Wärmeleitpads 15 der LED-Elemente 1 sind auf das Substrat 16 aufgelötet. Die Abstände der LED-Elemente 1 sind minimal und betragen rund 0.05 mm zur Vermeidung von mechanischen Spannungen während der Montage.

Weiter besitzt das LED-Beleuchtungsmodul ein Stromzuführungselement 21, welches z.B. über Abstandshalter direkt am Substrat 16 befestigt sein kann.

Das Stromzuführungselement 21 ist in Fig. 4 einzeln dargestellt. Mit Vorteil ist es als Leiterplatte ausgeführt, insbesondere aus FR4. Es ist selbsttragend, d.h. es verformt sich bei den im Betrieb durch Schwerkraft, Erschütterungen oder Bewegung auftretenden Kräften nicht wesentlich.

Im Bereich der LED-Elemente 1 ist das Stromzuführungselement 21 beabstandet vom Sekundär-Kühlelement 2 angeordnet, um thermische Spannungen zu vermeiden.

Im Bereich der LED-Elemente 1 verläuft das Stromzuführungselement 21 zudem mit Vorteil parallel zur Oberfläche bzw. Seitenkante des Sekundär-Kühlelements 2, und der Luftspalt 26 zwischen den Komponenten hat vorteilhaft eine Breite grösser 0.1 mm und/oder kleiner 5 mm.

Das Stromzuführungselement 21 bildet Stromzuführungsleitungen 22. Die Kontaktstellen 14 der LED-Elemente 1 sind direkt auf diese Stromzuführungsleitungen 22 aufgelötet.

Wie aus Fig. 4 ersichtlich, ist in das Stromzuführungselement 21 eine Vielzahl von Schlitzen 24 eingeschnitten, so dass es mehrere, voneinander beabstandete Zungen 25 bildet. Jede Kontaktstelle 14 eines LED-Elements 1 ist mit einer dieser Zungen 25 verbunden.

Dank Verwendung der erwähnten Zungen 25 werden die thermischen Spannungen an den Lötstellen, welche durch die unterschiedlichen Wärmeausdehnungskoeffizienten der Bauteile gebildet werden, reduziert, da sich die Zungen seitwärts federnd bewegen können.

Die LED-Elemente 1 und das Stromzuführungselement 21 können in einer Lötlehre gemeinsam verlötet werden.

*Zweite Ausführung LED- Beleuchtungsmodul*

Fig. 5 und 6 zeigen eine zweite Ausführung eines LED-Beleuchtungsmoduls. Es unterscheidet sich von der ersten Ausführung dadurch, dass auf dem Substrat 16 zwei Reihen von LED-Elementen 1 angeordnet sind. Beispielsweise können 24 LED-Elemente mit einer Anschlussleistung von $P_{elektrisch} \leq 100$ W vorgesehen sein.

Auf gegenüber liegenden Seiten und parallel und beabstandet vom Sekundär-Kühlelement 2 und auch zum Substrat 16 verlaufen in dieser Ausführung zwei Stromzuführungselemente 21. Jedes der Stromzuführungselemente 21 speist eine Reihe der LED-Elemente 1. Diese Geometrie erlaubt es, eine im Wesentlichen Linienförmige Lichtquelle hoher Leistung zu realisieren.

Das Substrat 16 wird wiederum auf einem Sekundär-Kühlelement 2 montiert.

*Erste Ausführung LED-Leuchtkörper*

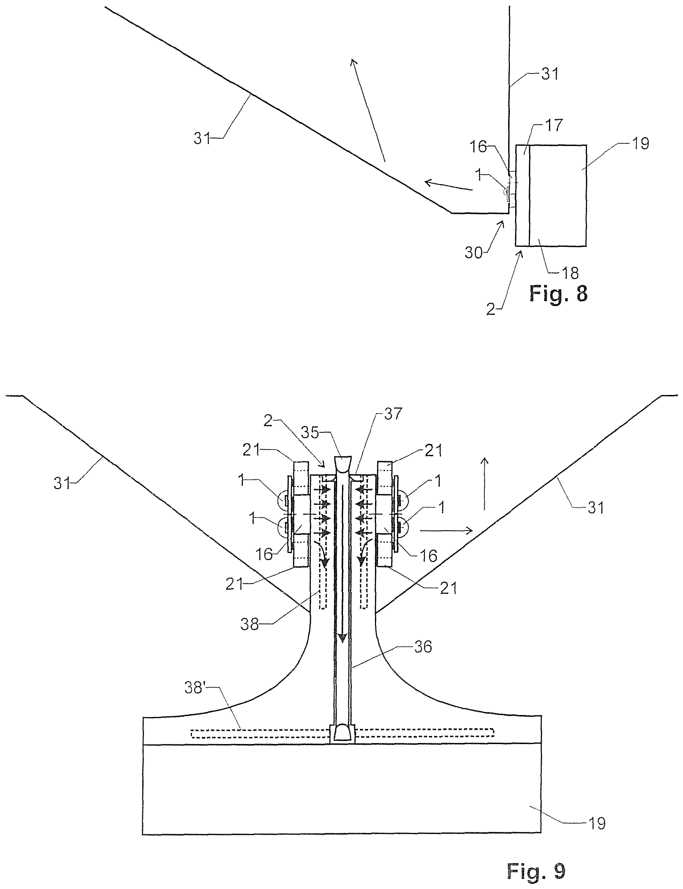

Fig. 8 zeigt eine erste Ausführung eines LED-Leuchtköpers, z.B. unter Verwendung von LED-Beleuchtungsmodulen gemäss Fig. 2 - 4 und 7.

Die Figur zeigt eine asymmetrische Tunnelleuchte mit drei 50W-Arrays (Systemleistung 150W), die zum Heatspreading die Phononen-Brechung an einer Grenzfläche gemäss Fig. 1 benutzt.

Weiter ist ein asymmetrischer Reflektor 31 vorgesehen, welcher das Licht von den LED-Beleuchtungsmodulen 30 verteilt.

Als Tertiär-Kühlelement 19 kann z.B. ein Rippenkühlkörper verwendet werden, in der in Fig. 7 dargestellten Weise.

*Zweite Ausführung LED-Leuchtkörper*

Fig. 9 zeigt einen symmetrischen Flutlichtstrahler unter Verwendung von Heatpipes 35.

In dieser Ausführung sind mindestens zwei LED-Beleuchtungsmodule 30 der oben beschriebenen Varianten vorgesehen, zwischen denen ein gemeinsames Sekundär-Kühlelement 2 angeordnet ist. Das Sekundär-Kühlelement 2 bildet ein T-Förmiges Kühlinterface, welches die Wärme an ein Tertiär-Kühlelement 19 abgibt. Das Tertiär-Kühlelement 19 ist beispielsweise als Rippenkühler oder Flüssigkeitskühler ausgestaltet.

Im Sekundär-Kühlelement 2 verlaufen mehrere Heatpipes 3, um die Wärme von den LED-Beleuchtungsmodulen zum Tertiär-Kühlelement 9 zu fördern. Vorteilhaft sind die Heatpipes 3 in Bohrungen angeordnet, welche sich durch das Sekundär-Kühlelement 2 erstrecken.

Dargestellt ist in Fig. 9 weiter eine Löt- oder Klebestelle 37 mit einem eingefrästen Lot- oder Klebstoffvorratsbehälter, der bei der Entgasung das überschüssige Lot oder den Klebstoff in Position hält.

Weiter zeigt Fig. 9 schematisch einen Reflektor 31, der symmetrisch um die LED-Beleuchtungsmodule angeordnet ist.

Die Flussrichtung $P_{th}$ des Wärmestroms ist in Fig. 9 mit Pfeilen dargestellt. Der primäre Wärmestrom tritt senkrecht in das Sekundär-Kühlelement 2 ein, wird vom Heatpipe-Array aufgenommen und zum Tertiär-Kühlelement 19 geführt. Im Falle von Systemstarttemperaturen unter dem Gefrierpunkt kann das Wärmetransport-Medium (z.B. Wasser) in den Heatpipes gefroren sein. In diesem Fall nimmt die Wärme den Weg mit den bogenförmigen Pfeilen durch das Kupfer des Sekundär-Kühlelements 2 und taut dabei das Eis auf. Sobald dieses vollständig geschmolzen ist, stellt sich der oben beschriebene Wärmetransportweg ein.

Beispielsweise können in dieser Ausführung vier der in Fig. 4 gezeigten LED-Beleuchtungsmodule zu 50 W eingesetzt werden, so dass die Gesamtleistung 200 W beträgt.

Werden zwei 200W-Systeme - d.h. total 400W - in einen Strahler mit den Gesamtabmessungen von L x B x H von 250 x 180 x 200mm bei einer Netto-Effizienz (d.h. Reflektorverluste und Light-Droop abgezogen) von 115 Lm/W eingebaut, lieferte die Leuchte einen gerichteten Lichtstrom von $\Phi_V$=46 kLm. Das reicht aus, um z.B. als Strahlerelement in der Beleuchtungsanlage eines Fussballstadion während 100'000h zu dienen. Bisherige LED-Systeme erreichen nur rund 5...10% dieser Leistungsdichte. Moderne Höchstdruck Xenon-Bogenlampen erreichen zwar diese Lichtströme problemlos - leben allerdings bloss einige hundert Stunden sind sehr teuer.

Alternativ oder Zusätzlich zu den Heatpipes 35 kann im Sekundär-Kühlelement 2 auch mindestens eine Aluminiumplatte vorgesehen sein, um die oben beschriebene phononische Brechung zu nutzen.

Beispielsweise kann im Sekundär-Kühlelement 2 ein Schlitz angeordnet werden, in welchem ein Körper 38 aus Aluminium angeordnet ist, wie dies in Fig. 9 gestrichelt angedeutet ist. Der Körper aus Aluminium 38 kann mit dem Kupfer z.B. wärmeleitend verklebt, verlötet oder verschraubt werden.

Alternativ oder zusätzlich kann auch auf der an das Tertiär-Kühlelement 19 anliegenden Seite des Sekundär-Kühlelements ein Körper 38' aus Aluminium vorgesehen sein, um die Wärmeverteilung auf das Tertiär-Kühlelement 19 über die phononische Brechung zu verbessern.

Um eine gute thermische Verbindung zwischen den Körpern 38 bzw. 38' mit dem Rest des Sekundär-Kühlelements 2 zu gewährleisten, können senkrecht zu den Schlitzebenen Schrauben vorgesehen sein, um die Schlitzwände gegen die Körper 38 bzw. 38' zu drücken.

Die Anordnung der Körper 38, 38' in Schlitzen des Sekundär-Kühlelements 2 hat den Vorteil, dass die aufwändige gleichzeitige Handhabung von mehreren, mit Wärmeleitpaste bestrichenen Teilen wegfällt. Es kann aber auch eine Sandwich-Bauweise verwendet werden. Beispielsweise kann zwischen dem Substrat 16 und dem Kupferkörper des Sekundär-Kühlelements eine A1999-Platte mit einer Dicke von z.B. 0.5 bis 1.5 mm gelegt werden. In ähnlicher Weise kann auch zwischen dem Fussbereich des Kupferkörpers des Sekundär-Kühlelements 2 und dem Kupfer-Tertiär-Kühlelement 19 ein Aluminium-Blech mit einer Dicke zwischen 2 und 10 mm angeordnet sein.

Bemerkungen:

Mit der vorliegenden Technik lässt sich ein lineares, planares oder nichtplanares (d.h. dreidimensionales) LED-Hochleistungs-Leuchtsystem realisieren. Insbesondere ist die Technik geeignet zum Kühlen einer oder mehrerer Reihen von LED-Elementen, wobei die Breite des von den LED-Elementen belegten Bereichs wesentlich kleiner als dessen Länge ist.

Der optische Füllfaktor *fo* kann grösser oder gleich 0.2 sein. (Anm: Der optische Füllfaktor *fo* wird bei einer Leuchtfläche definiert als der Quotient, der sich aus der Summe aller leuchtenden (Chip-)Flächen und der Fläche, die sich aus den Aussenbegrenzungen der leuchtenden Elemente einer bestimmten geometrischen Anordnung bildet.)

Die LED-Elemente können geclustert, d.h. ohne nennenswerten Abstand voneinander, montiert werden. Dabei können handelsübliche Leistungs-LED-Elemente - mit oder ohne Keramik-Submount - eingesetzt werden.

Die LED-Elemente können, wie erwähnt, auf einem Substrat angeordnet werden. Hierzu eignet sich insbesondere ein walzhartes, planes Kupfer- oder Silbersubstrat.

Die Befestigung der LED-Elemente auf dem Substrat erfolgt mit Vorteil mittels Lötung oder Klebung in wärmeschlüssiger Weise.

Das Substrat kann Vorrichtungen (z.B. Bohrungen oder Nasen) aufweisen, die eine definierte Ausrichtung der LED-Elemente relativ zur optischen Strahlerlinie und zur Montage auf dem Sekundär-Kühlelement durch Schrauben, Kleben, Löten oder Pressen besitzen.

Das Substrat kann zumindest auf der Montageseite der LED-Elemente aluminiert, d.h. mit einer Aluminiumschicht versehen sein, in welchem Fall es Bestandteil eines optischen Reflektorsystems bilden kann. Gleichzeitig ist dadurch auch ein wirkungsvoller Korrosionsschutz gegeben.

Das Sekundär-Kühlelement (auch als Wärmeverteiler oder Wärmekoppelinterface bezeichnet) gewährleistet den Wärmeübergang zu einem tertiären Kühlelement. Dabei wird die hohe Wärmedichte aus dem kleinen Substrat der LED-Elemente mittels eines Verbundmaterials mit einem hohen, aber in Strahlerrichtung konstanten Temperaturgradienten vermindert und in die grössere Wärmeableitfläche des Tertiärkühlers (in der Regel ein luftdurchströmter Finnen- oder Fingerkühlkörper) transportiert.

Das thermisch kontaktierte, planparallele Verbundmaterial des Sekundär-Kühlelements besteht auf der Warmseite aus einer ersten Materialschicht mit einem kleinen Quotienten aus der spezifischen Wärmekapazität und dem spezifischen Gewicht (z.B. Cu, Ag, oder Au), an welche auf der Kaltseite eine zweite Materialschicht anschliesst. Die zweite Materialschicht wird von einem Wärmeleiter mit einem grösseren Quotienten aus der spezifischen Wärmekapazität und dem spezifischen Gewicht (z.B. Al, Mg, C) gebildet, sodass an der Grenzfläche eine Phononen-Brechung nach dem inversen Gesetz von Snellius entsteht und der Verbund durch weniger Materialeinsatz (Gewicht und Volumen) mehr Wärmeleistung mit einer kleineren lateralen Temperaturdifferenz auf die Sekundärkühlfläche verteilen kann, als das dies eines der beiden Materialien für sich könnte.

Die erste Materialschicht ist mit Vorteil eine Metallschicht. Insbesondere besteht sie mit Vorteil zumindest zu 99.9 Gewichtsprozent aus mindestens einem Material aus der Gruppe von Kupfer, Silber und Gold, da schon geringe Legierungsbeimengungen die Wärmeleitfähigkeit stark beeinträchtigen können.

Auch die zweite Materialschicht ist mit Vorteil eine Metallschicht. Insbesondere besteht sie zumindest zu 90 Gewichtsprozent aus mindestens einem Material aus der Gruppe von Aluminium und Magnesium besteht. Bei der zweiten Materialschicht kann es sich jedoch auch um eine nichtmetallische Schicht handeln, insbesondere eine Schicht, welche zumindest zu 90 Gewichtsprozent aus Kohlenstoff besteht.

Aus Kosten- und Herstellungsgründen ist aus jetziger Sicht eine Kombination einer ersten Materialschicht aus zumindest 99 Gewichtsprozenten Kupfer und einer zweiten Materialschicht aus zumindest 90 Gewichtsprozenten Aluminium bevorzugt.

Wie im Zusammenhang mit der Ausführung nach Fig. 9 dargestellt, ist das Sekundär-Kühlelement nicht notwendigerweise planar aufgebaut. Dieses nichtplanares (z.B. doppelseitig planparalleles, quadratisches, rechteckiges, prismatisches, oder pyramidenstumpfförmiges) Sekundär-Kühlelement (auch als Wärmeverteiler oder Wärmekoppelinterface bezeichnet) der beispielsweise in Fig. 9 gezeigten Art verbindet die LED-Elemente mit dem Tertiär-Kühlelement und so mit der Wärmesenke der die Umgebung.

In dieser Ausführung tritt die Wärme aus den relativ kleinen, dicht gepackten LED-Elementen als Wärmestrom in die Montagefläche des Sekundär-Kühlelements, auf welchem die LED-Elemente montiert sind, und so in einen Körper aus einem hochwärmeleitenden Material (z.B. Cu, Ag, Al). Von dort gelangt die Wärme mit einem minimalen Temperaturgradienten in ein z.B. durch Lötung, Wärmeleitklebung oder Klemmung thermisch gekoppeltes Array aus Wärmerohren und wird so zur Wärmesenke bzw. zum Tertiär-Kühlelement transportiert.

Das Wärmerohr-Array kann parallel oder senkrecht zur Hauptabstrahlrichtung der LED-Elemente verlaufen.

Vorteilhaft für eine temperaturgradientenarme Wärmetransportfunktion ist die Achsparallelität des Wärmerohr-Arrays in der Senkrechten und/oder Waagrechten zur Montagefläche des LED-Arrays.

Bei der Ausführung nach Fig. 9 handelt es sich z.B. um ein planparalleles Doppel-Strahlerarray, bei dem die Wärmerohrachse parallel zur Querrichtung der Arrays, d.h. senkrecht zur Längsachse der LED-Reihe verläuft.

Die für eine bestimmte Leistung und Geometrie akzeptablen Temperaturgradienten lassen sich mittels eines FEM-Programms berechnen, und die Resultate thermographisch nachprüfen.

Wenn mehrere Wärmerohre vorgesehen sind, ist Redundanz gewährleistet. Damit bleibt das Gesamtsystem auch bei Ausfall eines bestimmten Anteils der Wärmerohre (z.B. durch Fabrikationsfehler) funktionstüchtig.

Die Methode der Wärmeabgabe an die Umgebung, d.h. die genaue Natur des Tertiär-Kühlelements ist nicht von Bedeutung.

Mit den beschriebenen Sekundär-Kühlelementen können auch andere LED-Array-Geometrien verwendet werden. So können auch Flächenarray-Geometrien mit einem optischen Füllfaktor $fo$, der grösser oder gleich 0.2 ist, realisiert werden. Ebenfalls können ein- oder zweireihige lineare LED-Arrays mit anderen geeigneten Sekundär-Kühlelementen betrieben werden.

Es wird also insbesondere ein neuartiges, geclustertes ein- oder doppelreihiges lineares LED-Array (Linienstrahler genannt) mit hoher Leistungsdichte beschrieben, bei welchem handelsübliche LED-Elemente (als Flip-Chip, gebondet oder auf einen Submount montiert) mit einem hohen optischen und thermischen Füllfaktor auf ein verhältnismässig dünnes Sekundär-Kühlelement montiert werden, z.B. mittels Lötung, Klebung oder Verschweissung. Dabei entstehen nahezu keine lateralen Temperaturgradienten, welche durch lokale Unterschiede in der thermischen Ausdehnung zu einem Verlust des thermischen Kontaktes zwischen Chip und Substrat führen können.

Die elektrischen Anschlüsse der LED und des Moduls sind vorzugsweise mittels eines geschlitzten und mit dem Sekundär-Kühlelement verbundenen Stromzuführungselements ebenfalls vor thermisch induzierter mechanischer Überbeanspruchung geschützt.

Während in der vorliegenden Anmeldung bevorzugte Ausführungen der Erfindung beschrieben sind, ist klar darauf hinzuweisen, dass die Erfindung nicht auf diese beschränkt ist und in auch anderer Weise innerhalb des Umfangs der folgenden Ansprüche ausgeführt werden kann.

**Patentansprüche**

1. LED-Beleuchtungsmodul mit
   mehreren LED-Elementen (1), von denen jedes einen LED-Halbleiterchip (13) aufweist,
   einem Substrat (16) zur Aufnahme der LED-Elemente (1), und
   einem Sekundär-Kühlelement (2), um Abwärme der LED-Elemente (1) abzuführen,
   einem Stromzuführungselement (21), das Stromzuführungsleitungen (22) für die LED-Elemente (1) aufweist,
   wobei die Stromzuführungsleitungen (22) mit den LED-Elementen (1) verbunden sind,
   wobei jedes LED-Element (1) einen elektrisch isolierenden Träger (11) und einen LED-Chip (12) auf einer ersten Seite des Trägers (11) aufweist, wobei die LED-Elemente (1) direkt oder indirekt auf dem Sekundär-Kühlelement (2) angeordnet sind und sich im thermischen Kontakt mit diesem befinden, wobei das Stromzuführungselement (21) beabstandet vom Substrat (16) angeordnet ist und parallel zu und beabstandet vom Substrat (16) verläuft, so dass zwischen dem Stromzuführungselement (21) und dem Substrat (16) ein Luftspalt ausgebildet ist,
   wobei am Träger (11) jedes LED-Elements (1) auf einer der ersten Seite gegenüber liegenden zweiten Seite Kontaktstellen (14) vorgesehen sind, welche direkt auf das Stromzuführungselement (21) aufgelötet sind,
   wobei das Stromzuführungselement (21) eine Vielzahl von voneinander beabstandeten Zungen (25) aufweist, wobei jede der Kontaktstellen (14) mit einer der Zungen (25) verbunden ist
   **dadurch gekennzeichnet, dass** für die Kontaktstellen (14) jedes LED-Elements (1) zwei separate Zungen (25) vorgesehen sind.

2. LED-Beleuchtungsmodul nach Anspruch 1, wobei das Sekundär-Kühlelement (2) aufweist:

   eine erste Materialschicht (3), wobei die LED-Elemente (1) auf einer ersten Seite der ersten Materialschicht (3) angeordnet sind, und
   eine zweite Materialschicht, welche an eine zweite Seite der ersten Materialschicht anschliesst, wobei die zweite Seite der ersten Seite gegenüberliegt,
   und wobei ein phononischer Brechungsindex $n_{\delta 1}$ der ersten Materialschicht kleiner ist als ein phononischer Brechungsindex $n_{\delta 2}$ der zweiten Materialschicht, wobei der phononische Brechungsindex eines Mediums gegeben ist durch

$$n_\delta = \frac{C_{Medium}}{\rho_{Medium}} \cdot \frac{1}{n_{\delta c}} + 1$$

   wobei $C_{Medium}$ die Wärmekapazität des Mediums ist, $\rho_{Medium}$ die Dichte des Mediums und $n_{\delta c} = 1 \ s^2 kg^2 K/m^5$, und wobei eine Wärmeleitung $\lambda_1$ der ersten Materialschicht grösser als eine Wärmeleitung $\lambda_2$ der zweiten Materialschicht ist.

3. LED-Beleuchtungsmodul nach Anspruch 2, wobei die erste Materialschicht eine Metallschicht ist, und insbesondere wobei sie zumindest zu 99.9 Gewichtsprozent aus einem Material aus der Gruppe von Kupfer, Silber und Gold besteht.

4. LED-Beleuchtungsmodul nach einem der Ansprüche 2 oder 3, wobei die zweite Materialschicht eine Metallschicht, ist und insbesondere wobei sie zumindest zu 90 Gewichtsprozent aus mindestens einem Material aus der Gruppe von Aluminium und Magnesium besteht.

5. LED-Beleuchtungsmodul nach einem der Ansprüche 2 oder 3, wobei die zweite Materialschicht zumindest zu 90 Gewichtsprozent aus Kohlenstoff besteht.

6. LED-Beleuchtungsmodul nach einem der Ansprüche 2 bis 5, wobei in einer Richtung senkrecht zur ersten Seite die erste Materialschicht eine Dicke von zwischen 0.4 bis 3 mm, und/oder die zweite Materialschicht eine Dicke zwischen 0.5 und 12 mm aufweist.

7. LED-Beleuchtungsmodul nach einem der Ansprüche 2 bis 6, wobei in einer Richtung senkrecht zur ersten Seite die erste Materialschicht eine Dicke aufweist, welche höchstens einer lateralen Ausdehnung von in den LED-Elementen (1) verwendeten LED-Chips (12) entspricht.

8. LED-Beleuchtungsmodul nach einem der Ansprüche 2 bis 7, wobei das Sekundär-Kühlelement (2) einen Körper aus dem ersten Material aufweist, in welchem ein Schlitz angeordnet ist, in dem ein Körper (38) aus dem zweiten Material angeordnet ist.

9. LED-Beleuchtungsmodul nach einem der vorangehenden Ansprüche, wobei der Luftspalt einer Breite von grösser 0.1 mm und/oder kleiner 5 mm besitzt.

10. LED-Beleuchtungsmodul nach einem der vorangehenden Ansprüche, wobei auf dem Substrat (16) zwei Reihen von LED-Elementen (1) angeordnet sind, und wobei auf gegenüber liegenden Seiten parallel zum und beabstandet vom Substrat (16) zwei Stromzuführungselemente (21) verlaufen, wobei jedes Stromzuführungselement (21) eine der Reihen von LED-Elementen (1) speist.

11. LED-Beleuchtungsmodul nach einem der vorangehenden Ansprüche, wobei das Stromzuführungselement (21) als Leiterplatte ausgeführt ist.

12. LED-Beleuchtungsmodul nach einem der vorangehenden Ansprüche, wobei der Träger (11) jedes LED-Elements (1) in einem Bereich gegenüber dem LED-Chip (12) auf das Substrat (16) aufgelötet ist.

13. LED-Beleuchtungsmodul nach einem der vorangehenden Ansprüche, wobei die LED-Elemente (1) entlang einer Richtung X in einer Reihenanordnung der Breite B angeordnet sind und wobei eine Ausdehnung des Sekundär-Kühlelements (2) senkrecht zur Richtung X und parallel zur LED-Elemente-seitigen Oberfläche des Sekundärkühlelements (2) mindestens 2·B, insbesondere mindestens 5·B, beträgt.

14. LED-Beleuchtungsmodul nach einem der vorangehenden Ansprüche, wobei das Sekundär-Kühlelement mehrere Heatpipes aufweist, um Wärme von den LED-Elementen fortzutragen,
und insbesondere wobei die Heatpipes in Bohrungen des Sekundär-Kühlelements (2) angeordnet sind,
und/oder insbesondere wobei die Heatpipes parallel zueinander verlaufen.

15. LED-Beleuchtungsmodul nach einem der vorangehenden Ansprüche, mit mindestens zwei Reihen von LED-Elementen, welche auf gegenüber liegenden Seiten des Sekundär-Kühlelements (2) angeordnet sind.

16. LED-Beleuchtungsmodul nach den Ansprüchen 14 und 15, wobei die Heatpipes von einem Bereich zwischen den LED-Elementen zu einer Anschlussfläche für ein Sekundär-Kühlelement verlaufen.

17. LED-Leuchtkörper mit mindestens einem LED-Beleuchtungsmodul nach einem der vorangehenden Ansprüche, sowie mit mindestens einen Tertiär-Kühlelement, welches zum Fortführen von Wärme thermisch mit dem Sekundär-Kühlelement (2) verbunden ist.


**Claims**

1. LED illumination module with
several LED elements (1), each of which comprises an LED semiconductor chip (13),
a substrate (16) for receiving the LED elements (1), and
a secondary cooling element (2) for carrying off waste heat from the LED elements (1),
a current supply member (21) having power leads (22) for the LED elements (1),
wherein the power leads (22) are connected to the LED elements (1),
wherein each LED element (1) comprises an electrically insulating carrier (11) and an LED chip (12) on a first side of the carrier (11),
wherein the LED-Elements (1) are arranged directly or indirectly on the secondary cooling element (2) and are in thermal contact with it,
wherein the current supply member (21) is arranged at a distance from the substrate (16) and extends parallel to and at a distance from the substrate (16), such that an air gap is formed between the current supply member (21) and the substrate (16),
wherein contact pads (14) are provided on the carrier (11) of each LED element (1) on a second side opposite to said first side, which contact pads are directly soldered to said current supply member (21),
wherein the current supply member comprises a plurality of mutually spaced apart tongues (25), wherein each of the contact pads (14) is connected to one of the tongues (25),
**characterized in that** two separate tongues (25) are provided for the contact pads of each LED-Element (1).

2. LED illumination module according to claim 1, wherein the secondary cooling element (2) comprises:

   a first material layer (3), wherein the LED elements (1) are arranged on a first side of the first material layer (3), and
   a second material layer, which is arranged adjacent to a second side of the first material layer, wherein the second side is opposite to said first side,
   and wherein a phononic index of refraction $n_{\delta 1}$ of the first material layer is smaller than an phononic index of refraction $n_{\delta 2}$ of the second material layer, wherein the phononic index of refraction of a medium is given by

$$n_\delta = \frac{C_{Medium}}{\rho_{Medium}} \cdot \frac{1}{n_{\delta c}} + 1$$

   wherein $C_{Medium}$ is the heat capacity of the medium, $\rho_{Medium}$ is the density of the medium and $n_{\delta c} = 1\ s^2kg^2K/m^5$, and wherein a thermal conductivity $\lambda_1$ of the first material layer is larger than a thermal conductivity $\lambda_2$ of the second material layer.

3. LED illumination module according to claim 2, wherein the first material layer is a metal layer, and in particular wherein it consists by at least 99.9 weight percent of a material selected from the group of copper, silver, and gold.

4. LED illumination module according to one of the claims 2 or 3, wherein the second material layer is a metal layer, and in particular wherein it consists by at least 90 weight percent of a material selected from the group of aluminium and manganese.

5. LED illumination module according to one of the claims 2 or 3, wherein the second material layer consists by at least 90 weight percent of carbon.

6. LED illumination module according to one of the claims 2 to 5, wherein, in a direction perpendicular to the first side, the first material layer has a thickness between 0.4 and 3 mm, and/or the second material layer has a thickness between 0.5 and 12 mm.

7. LED illumination module according to one of the claims 2 to 6, wherein, in a direction perpendicular to the first side, the first material layer has a thickness that corresponds to no more than a lateral extension of the LED chips (12) used in the LED elements (1).

8. LED illumination module according to one of the claims 2 to 7, wherein the secondary cooling element (2) comprises a body of the first material in which a slit is arranged, wherein a body (38) of the second material is arranged in said slit.

9. LED illumination module according to one of the preceding claims, wherein the air gap has a width larger than 0.1 mm and/or smaller than 5 mm.

10. LED illumination module according to one of the preceding claims, wherein two rows of LED elements (1) are arranged on the substrate (16), and wherein two current supply members (21) extend on opposite sides, parallel to and at a distance from the substrate (16), wherein each current supply member (21) feeds one of the rows of LED elements (1).

11. LED illumination module according to one of the preceding claims, wherein the current supply member (21) is formed by a printed circuit board.

12. LED illumination module according to one of the preceding claims, wherein the carrier (11) of each LED element (1) is soldered to the substrate (16) in a region opposite the LED chip (12).

13. LED illumination module according to one of the preceding claims, wherein the LED elements (1) extend along a direction X in a row configuration of a width B, and wherein an extension of the secondary cooling element (2), perpendicular to the direction X and parallel to the surface of the secondary cooling element (2) facing the LED elements, is at least 2·B, in particular at least 5·B.

14. LED illumination module according to one of the preceding claims, wherein the secondary cooling element comprises several heat pipes to carry off heat from the LED elements,
and in particular wherein the heat pipes are arranged in bores of the secondary cooling element (2),
and/or in particular wherein the heat pipes extend parallel to each other.

15. LED illumination module according to one of the preceding claims, with at least two rows of LED elements arranged on opposite sides of the secondary cooling element (2).

16. LED illumination module according to the claims 14 and 15, wherein the heat pipes extend from a region between the LED elements to an interface surface for the secondary cooling element.

17. LED lamp with at least one LED illumination module according to one of the preceding claims, and with at least one tertiary cooling element thermally connected to the secondary cooling element (2) for carrying off heat.

**Revendications**

1. Module d'éclairage LED avec
plusieurs éléments LED (1), chacun d'eux comprenant une puce semi-conductrice LED (13),
un substrat (16) pour recevoir les éléments LED (1), et
un élément de refroidissement secondaire (2) pour évacuer la chaleur résiduelle des éléments LED (1),
un élément d'alimentation en courant (21) ayant des fils d'alimentation (22) pour les éléments LED (1),
les conducteurs d'alimentation (22) étant connectés aux éléments LED (1),
chaque élément LED (1) comprenant un support électriquement isolant (11) et une puce LED (12) sur un premier côté du support (11),
les éléments LED (1) étant disposés directement ou indirectement sur l'élément de refroidissement secondaire (2) et étant en contact thermique avec celui-ci,
l'élément d'alimentation en courant (21) étant disposé à une distance du substrat (16) et s'étendant parallèlement au substrat (16) et à une distance de celui-ci, de sorte qu'une fente d'air est formé entre l'élément d'alimentation en courant (21) et le substrat (16),
des plages de contact (14) étant prévues sur le support (11) de chaque élément LED (1) sur un deuxième côté opposé audit premier côté, lesdites plages de contact étant directement soudées sur ledit élément d'alimentation en courant (21),
l'élément d'alimentation en courant comprenant une pluralité de languettes mutuellement espacées (25), chacune des plages de contact (14) étant connectée à l'une des languettes (25),
**caractérisé en ce que** deux languettes séparées (25) sont prévues pour les plages de contact de chaque élément LED (1).

2. Module d'éclairage LED selon la revendication 1, dans lequel l'élément de refroidissement secondaire (2) comprend:

une première couche de matériau (3), les éléments LED (1) étant disposés sur un premier côté de la première couche de matériau (3), et
une deuxième couche de matériau, qui est disposée adjacente à un deuxième côté de la première couche de matériau, dans laquelle le deuxième côté étant opposé audit premier côté,
et un indice de réfraction phononique $n_{\delta 1}$ de la première couche de matériau étant inférieur à un indice de réfraction phononique $n_{\delta 2}$ de la deuxième couche de matériau, l'indice de réfraction phononique d'un milieu étant donné par

$$n_\delta = \frac{C_{Medium}}{\rho_{Medium}} \cdot \frac{1}{n_{\delta c}} + 1$$

$C_{Medium}$ étant la capacité thermique du milieu, $\rho_{Medium}$ étant la densité du milieu et $n_{\delta c} = 1\ s^2 kg^2 K/m^5$,
et une conductivité thermique $\lambda_1$ de la première couche de matériau étant supérieure à une conductivité thermique $\lambda_2$ de la deuxième couche de matériau.

**3.** Module d'éclairage LED selon la revendication 2, dans lequel la première couche de matériau est une couche métallique, et en particulier étant constituée par au moins 99,9 % en poids d'un matériau choisi dans le groupe du cuivre, de l'argent et de l'or.

**4.** Module d'éclairage LED selon l'une des revendications 2 ou 3, la deuxième couche de matériau étant une couche métallique, et en particulier étant constituée d'au moins 90 % en poids d'un matériau choisi dans le groupe comprenant l'aluminium et le manganèse.

**5.** Module d'éclairage LED selon l'une des revendications 2 ou 3, la deuxième couche de matériau étant constituée d'au moins 90 % en poids de carbone.

**6.** Module d'éclairage LED selon l'une des revendications 2 à 5, dans lequel, dans une direction perpendiculaire au premier côté, la première couche de matériau a une épaisseur comprise entre 0,4 et 3 mm, et/ou la deuxième couche de matériau a une épaisseur comprise entre 0,5 et 12 mm.

**7.** Module d'éclairage LED selon l'une des revendications 2 à 6, dans lequel, dans une direction perpendiculaire au premier côté, la première couche de matériau a une épaisseur qui correspond au maximum à une extension latérale des puces LED (12) utilisées dans les éléments LED (1).

**8.** Module d'éclairage LED selon l'une des revendications 2 à 7, dans lequel l'élément de refroidissement secondaire (2) comprend un corps du premier matériau dans lequel une fente est disposée, un corps (38) du second matériau étant disposé dans ladite fente.

**9.** Module d'éclairage LED selon l'une des revendications précédentes, la fente d'air ayant une largeur supérieure à 0,1 mm et/ou inférieure à 5 mm.

**10.** Module d'éclairage LED selon l'une des revendications précédentes, dans lequel deux rangées d'éléments LED (1) sont disposées sur le substrat (16), et dans lequel deux éléments d'alimentation en courant (21) s'étendent sur des côtés opposés, parallèlement au substrat (16) et à distance de celui-ci, chaque élément d'alimentation en courant (21) alimentant une rangée des éléments LED (1).

**11.** Module d'éclairage LED selon l'une des revendications précédentes, dans lequel l'élément d'alimentation en courant (21) est formé par une carte de circuit imprimé.

**12.** Module d'éclairage LED selon l'une des revendications précédentes, le support (11) de chaque élément LED (1) étant soudé sur le substrat (16) dans une zone opposée à la puce LED (12).

**13.** Module d'éclairage LED selon l'une des revendications précédentes, dans lequel les éléments LED (1) s'étendent le long d'une direction X dans une configuration en rangée d'une largeur B, et dans lequel une extension de l'élément de refroidissement secondaire (2), perpendiculaire à la direction X et parallèle à la surface de l'élément de refroidissement secondaire (2) tournée vers les éléments LED, est au moins 2·B, en particulier au moins 5·B.

**14.** Module d'éclairage LED selon l'une des revendications précédentes, dans lequel l'élément de refroidissement secondaire comprend plusieurs caloducs pour évacuer la chaleur des éléments LED,
et en particulier dans lequel les caloducs sont disposés dans des alésages de l'élément de refroidissement secondaire (2),
et/ou en particulier dans laquelle les caloducs s'étendent parallèlement les uns aux autres.

**15.** Module d'éclairage LED selon l'une des revendications précédentes, avec au moins deux rangées d'éléments LED disposées sur les côtés opposés de l'élément de refroidissement secondaire (2).

**16.** Module d'éclairage à LED selon les revendications 14 et 15, les caloducs s'étendant à partir d'une zone entre les éléments LED jusqu'à une surface d'interface pour l'élément de refroidissement secondaire.

**17.** Lampe à LED avec au moins un module d'éclairage LED selon l'une des revendications précédentes et avec au moins un élément de refroidissement tertiaire relié thermiquement à l'élément de refroidissement secondaire (2) pour évacuer la chaleur.

Fig. 2

Fig. 3

Fig. 4

Fig. 5

Fig. 6

Fig. 1

Fig. 7

31

31

16

1

17

19

30

18

2

**Fig. 8**

2

35

37

21

21

31

1

1

31

1

1

16

16

21

21

38

36

38'

19

**Fig. 9**

**IN DER BESCHREIBUNG AUFGEFÜHRTE DOKUMENTE**

**In der Beschreibung aufgeführte Patentdokumente**

- EP 2665092 A
- WO 2012134305 A